# EUROPÄISCHE PATENTSCHRIFT

(11) **EP 1 794 885 B1**
(45) Veröffentlichungstag und Bekanntmachung des Hinweises auf die Patenterteilung: **26.05.2010**
(21) Anmeldenummer: 05787145.1
(22) Anmeldetag: 19.09.2005
(51) Int. Cl.: H03K 17/0814

(54) **ELEKTRONISCHES SCHALTGERÄT, INSBESONDERE LEISTUNGSSCHALTER, UND ZUGEHÖRIGE BETRIEBSWEISE**
ELECTRONIC SWITCHING DEVICE, IN PARTICULAR CIRCUIT-BREAKER AND ASSOCIATED OPERATING METHOD
COMMUTATEUR ELECTRONIQUE, NOTAMMENT DISJONCTEUR, ET MODE DE FONCTIONNEMENT ASSOCIE

(30) Priorität: 27.09.2004 DE 102004046823
(43) Veröffentlichungstag der Anmeldung: 13.06.2007
(73) Patentinhaber: SIEMENS AKTIENGESELLSCHAFT, 80333 München (DE)
(72) Erfinder: MAIER, Reinhard, 91074 Herzogenaurach (DE); RUPP, Jürgen, 91056 Erlangen (DE); SCHRÖCK, Michael, 92289 Ursensollen (DE)
(86) Internationale Anmeldenummer: PCT/EP2005/054643
(87) Internationale Veröffentlichungsnummer: WO 2006/034969

(56) Entgegenhaltungen:
- EP-A- 0 272 898
- EP-A- 0 620 645
- EP-A- 0 785 625
- WO-A-2004/049566
- DE-A1- 10 147 696
- BILDGEN M ED - INSTITUTE OF ELECTRICAL AND ELECTRONICS ENGINEERS: "From standard to intelligent MOSFET" PROCEEDINGS OF THE INDUSTRY APPLICATIONS SOCIETY ANNUAL MEETING. HOUSTON, OCT. 4 - 9, 1992, NEW YORK, IEEE, US, Bd. VOL. 1, 4. Oktober 1992 (1992-10-04), Seiten 1212-1217, XP010063620 ISBN: 0-7803-0635-X

## Beschreibung

Die Erfindung bezieht sich auf ein elektronisches Schaltgerät, insbesondere einen Leistungsschalter. Daneben bezieht sich die Erfindung auch auf die zugehörige Betriebsweise des Schaltgerätes.

Zum Schalten von Wechselstrom werden bekanntermaßen elektromechanische und elektronische Schaltgeräte eingesetzt. Bei den elektromechanischen Schaltgeräten wird zwischen Schaltgeräten für betriebsmäßiges Schalten ("Schütze") und für Kurzschlussschalten ("Leistungsschalter") unterschieden. Eine Überlast kann je nach Schutzkonzept vom Leistungsschalter bzw. vom Schütz geschaltet werden.

Die in der Praxis eingesetzten elektronischen Schaltgeräte beruhen auf einer Thyristortechnik und sind nur für betriebsmäßiges Schalten bzw. Überlastschalten geeignet. Daneben kommen zunehmend Leistungshalbleiter in Betracht: Insbesondere die sog. "Kaskode" ist dabei als Kombination aus zwei antiseriell geschalteten SiC-JFET und SI-MOSFET als aktuelle Entwicklung bekannt.

Ein elektronischer Leistungsschalter, der sowohl zum betriebsmäßigen Schalten, bei Überlast als auch zum Kurzschlussschalten geeignet ist, ist Gegenstand vorliegender Anmeldung. Dabei werden die bisherigen Ansätze des elektronischen Leistungsschalters mit neuen erweiterten Funktionalitäten kombiniert.

Elektronische Leistungsschalter müssen folgende Funktionen/Schalt-Eigenschaften (EIN, AUS) aufweisen:
- unverzögert EIN
- ggf. phasengesteuert EIN
- unverzögert betriebsmäßig: AUS, z.B. für ohmsche Lasten
- Ausschalten im Stromnulldurchgang: betriebsmäßig und bei Überlast, insbes. wegen Abschalten großer Induktivitäten wie z.B. von Motoren
- Kurzschlussschutz Kaskode: sofort AUS
- Überlastschutz Kaskode: Entspricht dem Überlastschutz für elektronischen Leistungsschalter
- evtl. Überlastschutz Abzweig: Dies entspricht dem Überlastschutz für Motoren, Leitungen
- Überspannungsschutz für Elektronischen Leistungsschalter
- potentialgetrennte Ansteuerung
- potentialgetrennte Statusmeldung
- Stromversorgung auf Schalterpotential

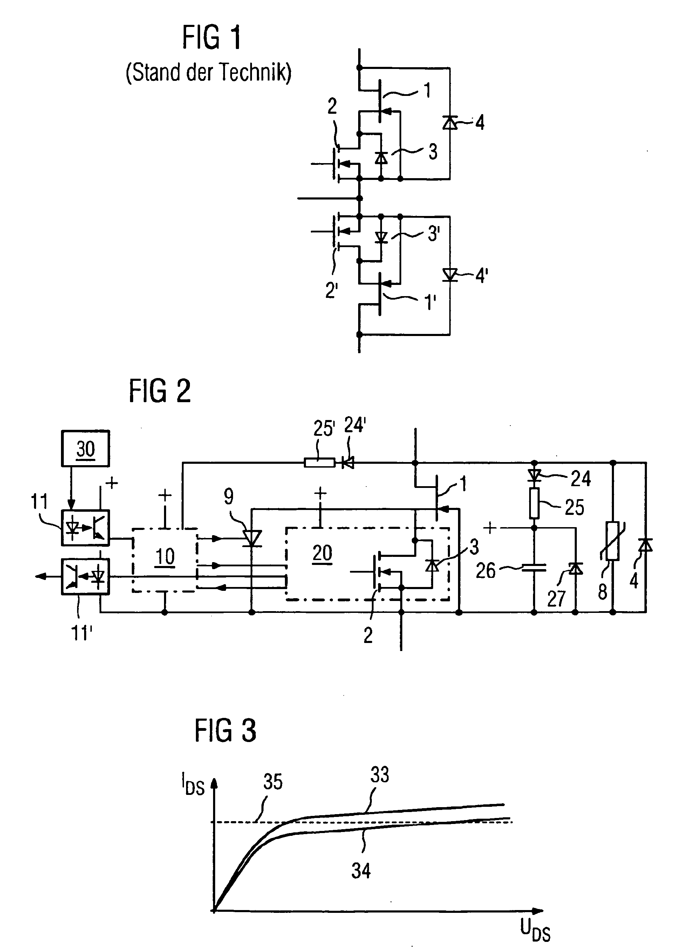

Das eigentlich leistungsschaltende Element ist dabei eine antiserielle Kaskodenschaltung vom bereits erwähnten Kombination aus SiC-JFET und Si-MOSFET, was im Einzelnen in Figur 1 der Zeichnung dargestellt ist und weiter unten noch im Einzelnen beschrieben wird.

Mit der vom Stand der Technik vorbekannten Schaltung gemäß Figur 1 lassen sich aber nur die Funktionen:
- unverzögert EIN und
- unverzögert AUS
realisieren. Die anderen, oben erwähnten Funktionen können damit nicht verwirklicht werden.

Die Funktionen "phasengesteuert EIN" und "Überlastschutz: Abzweig" sind im Verbund mit den anderen Phasen in einem Sanftstarter-Steuerteil bzw. einer Überlastschutzeinheit, die Verbraucher (Motorschutz) und Betriebsmittel wie z.B. Leitungen schützt, realisierbar. Eine solche Einheit wird in Sanftstartern mit Thyristoren bereits verwendet und gehört für sich gesehen zum Stand der Technik.

Die Zusatzschaltung in der Einzelphase muss neben "unverzögert EIN" und "unverzögert AUS" daher folgende Funktionen erfüllen:
- Ausschalten in Stromnulldurchgang
- Kurzschlussschutz Kaskode
- Überlastschutz Kaskode
- Überspannungsschutz
- potentialgetrennte Ansteuerung
- potentialgetrennte Statusmeldung
- Stromversorgung auf Schalterpotential.

Als Stromventile eignen sich - wie bereits erwähnt - Geräte mit Thyristoren. Thyristor-Schaltgeräte bestehen aus einem Steuerteil auf Steuerpotential und den jeweiligen Schaltelementen auf Hauptspannungspotential. Je nach Gerät können in dem Steuerteil folgende Funktionen/Schalteigenschaften hinterlegt sein:
- unverzögert EIN
- phasengesteuert EIN (sog. "Sanftstart")
- betriebsmäßig AUS im nächstfolgenden Nulldurchgang durch Thyristor
- Überlastschutz für Leistungsteil
- Überlastschutz für Abzweig
- potentialgetrennte Ansteuerung
- potentialgetrennte Statusmeldung, diese ist derzeit nur in Ansätzen im übergeordneten Steuergerät realisiert.

Ein Ausschalten im Stromnulldurchgang betriebsmäßig und bei Überlast erfolgt durch die Bauteileigenschaft des Thyristors. Ein Kurzschluss führt hingegen zur Zerstörung des Gerätes, sofern es nicht von einem übergeordneten Schaltelement geschützt wird.

Vom Stand der Technik sind Konzepte bekannt, die einen elektronischen Leistungsschalter beschreiben, wozu z.B. auf die DE 196 12 216 A1 und die US 5 216 352 A verwiesen wird. Hierbei werden Transistoren eingesetzt.

Die oben genannten Funktionen werden durch einzelne Funktionseinheiten erreicht. Hierbei ist meist eine Erfassung der Strommomentanwerte erforderlich, was folgendermaßen erfolgen kann:
- Strommessung: Erfolgt über Wandler, Shunt, Stromspiegel in Halbleiter.
- Ausschalten in Stromnulldurchgang: Erfolgt durch Auswertung des Stromsignals mittels Komparator und entsprechender Signalgabe an Kaskode.
- Kurzschlussschutz Kaskode: Es erfolgen "U_{CE}"-Überwachung bzw. Strom-Momentanwert-Überwachung. Dazu erfolgen bekannte Verfahren nach TOK (Tolerantes Ortskurven-Kriterium, oder die Verhinderung des Kurzschlussdraufschaltens durch Testpuls.
- Überlastschutz Kaskode: Erfolgt über verzögerte Stromauswertung/Kennlinie für Kurzzeit-Überlast, div. Erwärmungsmodelle, Temperatursensor für Langzeit-Überlastschutz.
- Überspannungsschutz: Erfolgt über Clamping, Zenerdioden, Varistoren.
- potentialgetrennte Ansteuerung, potentialgetrennte Statusmeldung: Erfolgt über Optokoppler, Übertrager ggf. als IC, über R/C-Spannungsteiler zwischen L und N. Die Signalübertragung wird auf Stromversorgung mit Pulsbreitenmodulation aufmoduliert; möglich auch MR-Koppler.
- Stromversorgung auf Schalterpotential:
   Kann transformatorisch aus L-N bzw. L-L erfolgen über Impedanz/Dioden aus L-N bzw. L-L, ggf. mit künstlichem Sternpunkt, über R/C Spannungsteiler zwischen L und N, über kurzzeitig gesperrte Halbleiter-Schaltelemente und Kondensatoraufladung, aus Strom/Spannungwandlersignal, DC/DC-Wandler z.B. Burr Brown, AC/DC-Wandler z.B. Trafo, Ultraschall durch Piezo-Übertrager, optisch über Lichtleiter/Photozelle, Kombination Heiz-/Thermoelement.

Weiterhin ist aus der DE 100 62 026 A1 eine elektronische Schalteinrichtung bekannt, die eine Arbeitsschaltung zum Anlegen an die Betriebsspannung umfasst, bei der Ausschaltmittel vorhanden sind, die im Gefährdungsfall das Schaltelement unter Ausnutzung der im Betriebsstrom bzw. der Betriebsspannung enthaltenen Energie selbsttätig in den ausgeschalteten Zustand bringen. Dazu ist ein SiC-JFET vorhanden. Bei der DE 196 00 807 A1 ist dagegen ein intelligentes, getrenntes Halbbrückenleistungsmodul vorhanden, das wenigstens einen Leistungstransistor umfasst, wobei dieser durch einen Überspannungsklemmen- und Entsättigungsdetektionskreis geschützt wird. Jedem Leistungstransistor ist dabei ein Trenntransformator zugeordnet, wobei dessen Primärwicklungen mit einer davon getrennten Ansteuerungskommunikationsschnittstelle verbunden sind. Die Gate-Ansteuerungsvorrichtung des Leistungstransistors ist dabei an die Sekundärwicklung des Transformators angeschlossen. Schließlich ist aus der DE 69 124 740 T2 ein monolitisches stromgesteuertes Unterbrechungssystem bekannt, bei dem über eine geeignete Mikroprozessorsteuerung im Nulldurchgang, bei dem die Energie vernachlässigbar ist, gegebenenfalls abgeschaltet wird.

Sofern obige Schaltungen auch die Funktionen eines Leistungsschalters erfüllen sollen, sind sie äußerst komplex aufgebaut.

Davon ausgehend ist es Aufgabe der Erfindung, ein Schaltgerät vorzuschlagen, mit dem insbesondere auch die Funktionen eines Leistungsschalters erfüllt werden.

Die Aufgabe ist erfindungsgemäß bei einem Schaltgerät der eingangs genannten Art durch die Gesamtheit der Merkmale des Patentanspruches 1 gelöst. Die zugehörige Betriebsweise ist Gegenstand des Patentanspruches 10. Jeweilige Weiterbildungen werden in den abhängigen Ansprüchen angegeben.

Gegenstand der Erfindung ist die spezifische Kaskodenschaltung eines SiC-JFET mit einem als so genannten SPM (Smart Power MOSFET) ausgebildeten MOSFET und einem Thyristor mit zugehörigem Ansteuerteil, wobei der Thyristor dem SPM parallel geschaltet ist und wobei eine separate Logik-Schaltung vorhanden ist, die zur Koordination des SPM mit der Thyristorschaltung dient.

Weitere Einzelheiten und Vorteile der Erfindung ergeben sich aus der nachfolgenden Figurenbeschreibung von Ausführungsbeispielen anhand der Zeichnung in Verbindung mit den Patentansprüchen. Es zeigen
- Figur 1: das Prinzip einer antiseriellen Kaskodenschaltung gemäß dem Stand der Technik,
- Figur 2: eine Hälfte einer Schaltkreisanordnung mit der Kombination eines SiC-JFETs speziell mit einem SPM und der zugehörigen Logikschaltung,
- Figur 3: eine graphische Darstellung der Kennlinien von SiC-JFET und der Ausgangskennlinie eines SPM,
- Figur 4: den Programmablauf in der Logikschaltung gemäß Figur 2,
- Figur 5: die Schaltzustände der SiC-Kaskode mit Thyristor und den zugehörigen Übergängen,
- Figuren: 6 bis 9 Stromverläufe der SPM und des Thyristors für verschiedene Schaltzustände und
- Figur 10: eine graphische Darstellung zur Fehlererkennung.

In der Figur 1 ist eine antiserielle Kaskodenschaltung gemäß dem Stand der Technik dargestellt. Sie besteht aus zwei SiC-JFETs 1 und 1', die jeweils mit einem Si-MOSFET 2 bzw. 2' zusammengeschaltet sind. Dabei ergibt sich aus den Elementen 1, 2 und 1', 2' eine antiseriell in Reihe geschaltete Anordnung. Es ist jeweils eine Sperrdiode 3 bzw. 3' vorhanden. Die Diode 4 bzw. 4' übernimmt den Strom in Rückwärtsrichtung.

In Figur 2 ist ein thyristorbasiertes Sanftstarter-Steuerteil mit Überlastschutzfunktion mit einem so genannten SPM (Smart Power MOSFET) kombiniert. Dabei ist in Figur 2 nur die eine Hälfte der Schaltung dargestellt. Dieselbe Schaltung muss antiseriell entsprechend Figur 1 in Reihe geschaltet werden, um insbesondere einen Wechselspannungsschalter zu ergeben.

Im Einzelnen bedeuten in Figur 2 Bezugszeichen 1 wiederum den SiC-JFET aus Figur 1. Der SPM ist insgesamt mit 20 bezeichnet. Weiterhin ist ein Thyristor 9 mit einem zugehörigen Steuerteil 30 vorhanden. Das Zusammenwirken von SPM 20 und Thyristor 9 wird durch einen Logikbaustein 10 gewährleistet. Über den Logikbaustein 10 können damit softwaremäßig Funktionen des SPM 20 mit dem Thyristor 9 verknüpft werden.

In Figur 2 fließt der Strom in Sperrrichtung entsprechend Figur 1 durch die Diode 4. Ein Varistor 8 dient dem Überspannungsschutz.

Weiterhin sind in der Figur 2 noch Dioden 24, 24' und Widerstände 25, 25', ein Kondensator 26 und eine Zenerdiode 7 als Spannungsbegrenzer vorhanden. Derartige Beschaltungen gehören zum Stand der Technik.

SPMs sind MOSFETs, die mit einer zusätzlichen Logik und meist einem Temperatur- und Stromsensor ausgestattet sind. Häufig wird auch ein Fehlerzustand, wie z.B. Kurzschluss oder Überlast, als Statusmeldung ausgegeben. Durch die Auswertung des Stromsignals wird ein Kurzschluss entweder sofort abgeschaltet oder der Strom wird auf einen zulässigen Wert begrenzt. Durch eine sorgfältige Abstimmung von SiC-JFET und SPM lässt sich auch der SiC-JFET durch den SPM gegen Überlast und Kurzschluss schützen.

Der Einsatz der SPM dient beim Schalten für unverzögertes EIN, unverzögertes AUS, zum Kurzschlussschutz, zur Strombegrenzung und mit Hilfe der integrierten Temperaturüberwachung als
Überlastschutz der Kaskode.

Bei einer Schaltkreisanordnung gemäß Figur 2 ist es vorteilhafterweise möglich, das Steuerteil 30 eines ansonsten unveränderten thyristorbasierten-Motorsteuergerätes, z.B. eines so genannten Sanftstarters, weitgehend unverändert zu verwenden.

In Figur 3 ist in einer graphischen Darstellung der Ströme in Abhängigkeit von der Spannung dargestellt. Aufgetragen sind auf der Abszisse die Spannung U_{DS} und auf der Ordinate der Strom I_{DS}. Mit 33 ist eine Kennlinie eines SiC-JFETs und mit 34 eine Ausgangskennlinie eines SPM dargestellt. Bezugszeichen 35 repräsentiert den Schutzschwellwert.

Gemäß Figur 3 ist der Sättigungsstrom I_{DS} beim SPM geringer als beim SiC-JFET. Damit wird die U_{DS}-Spannung des SPM bei Erreichen des Sättigungsstroms des SPMs 20 rasch ansteigen, der Kurzschlussschutz bzw. die Strombegrenzung einsetzen und der SiC-JFET nie in einen unzulässigen Betriebszustand (Sättigung) kommen können. Ebenso kann die Temperaturüberwachung des SPM den SiC-JFET schützen, wenn die Erwärmung des SiC-JFET durch z.B. größeren Kühlkörper geringer ist als die des SPM bzw. die Wärmefestigkeit des SiC-JFET höher ist als die des SPM.

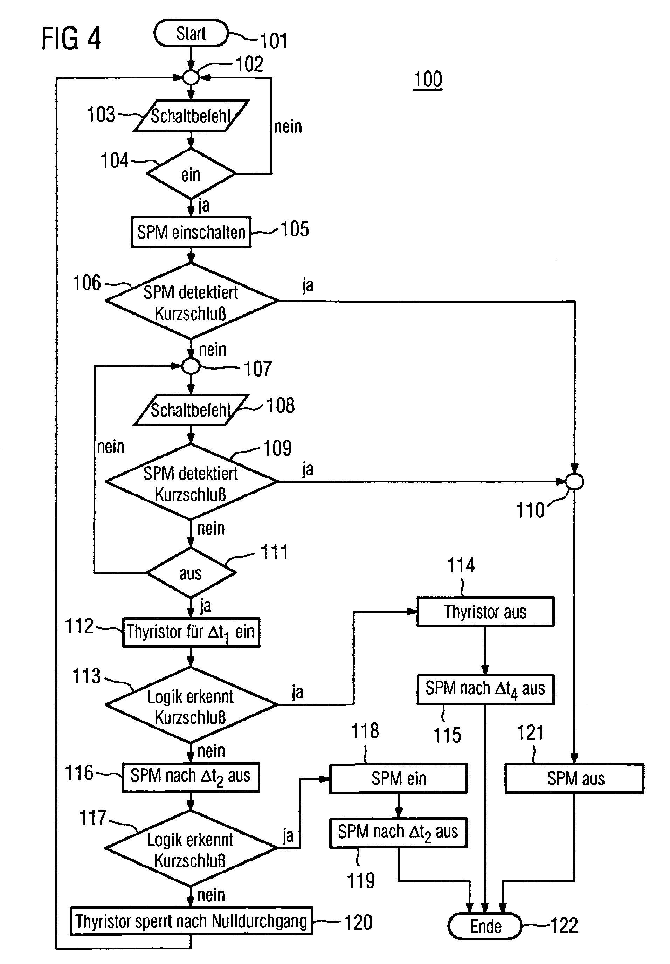

Durch den Einsatz des Thyristors 9 parallel zum SPM 20 erfolgt das Ausschalten im Stromnulldurchgang, wobei die Logikschaltung 10 zur Koordinierung von SPM 20 und Thyristor 9 dient. In der Logikschaltung bzw. -baustein ist softwaremäßig ein Ablaufschema gemäß Figur 4 implementiert, das anhand des nachfolgenden Flussdiagramms beschrieben wird. Das Flussdiagramm ist in seiner Struktur weitgehend selbsterklärend.

Anhand Figur 4 werden die Schaltzustände der Programmstruktur 100 beschrieben:

Bei Position 101 wird ein Startbefehl gegeben. Nach einer Verknüpfungsposition 102 folgt ein Schaltbefehl 103 und eine Entscheidung bei Position 104. Bei Position 105 wird der SPM 20 eingeschaltet, der bei Position 106 einen Kurzschluss detektiert. Ist ein Kurzschluss detektiert, so folgt der Entscheidungsweg längs der Linie mit der Bezeichnung "ja" und schaltet bei Position 121 den SPM 20 aus. Es folgt ein Verknüpfungspunkt 107 mit einem anschließenden Schaltbefehl 108 und eine Entscheidungsstufe 109. Ist ein Kurzschluss detektiert, wird wiederum der SPM entsprechend Position 121 ausgeschaltet.

Ist kein Kurzschluss detektiert, wird in der Entscheidungsroute 111 auf 107 zurückgesetzt.

Entsprechend Position 112 wird ein Thyristor für die Zeit Δt₁ eingeschaltet. In Position 113 erkennt die Logikschaltung 10 einen Kurzschluss. Ist ein Kurzschluss vorhanden, wird die Thyristorschaltung gemäß Position 114 ausgeschaltet und die SPM 20 wird nach einem Zeitintervall Δt₄ entsprechend Position 115 ebenfalls ausgeschaltet.

Liegt kein Kurzschluss vor, wird der SPM 20 nach einem Zeitintervall Δt₂ entsprechend Position 116 ausgeschaltet. In der Entscheidungsraute gemäß Position 117 erkennt die Logik 10 einen Kurzschluss und schaltet über den Pfad c den SPM 20 entsprechend Position 118 ein. Liegt kein Kurzschluss vor, sperrt die Thyristoransteuerschaltung 30 entsprechend Position 120 nach dem Nulldurchgang.

Entsprechend Position 118 wird der SPM 20 nach ΔT₃ ausgeschaltet. Am Punkt 122 ist das Ende des Programmablaufes erreicht.

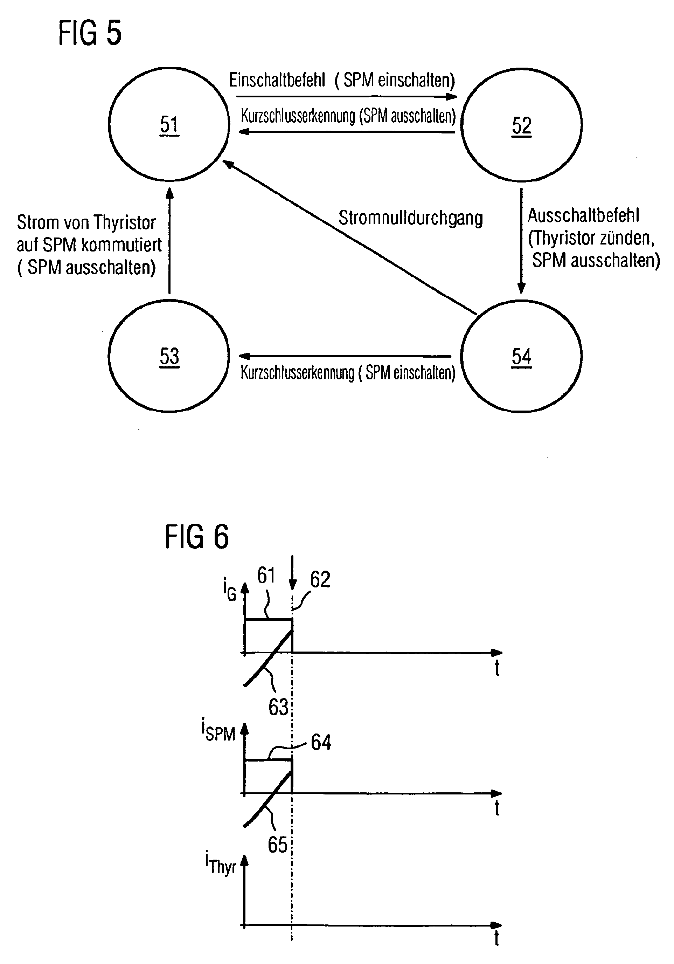

Anhand von Zustandsgraphen ist in Figur 5 der wesentliche Funktionszusammenhang verdeutlicht: Die Schaltzustände der SiC-Kaskode mit SPM 20 und des Thyristors 9 sind als Kreise und die zugehörigen Übergänge als Pfeile dargestellt, so dass der Zustandsgraph das Zusammenwirken verdeutlicht. Position 51 präsentiert den offenen Schalter, d.h. hier sind der SPM 20 und der Thyristor 9 nichtleitend. Der Kreis 52 repräsentiert den geschlossenen Schalter. In diesem Fall ist der SPM 20 geschlossen und der Thyristor 9 offen. Der Kreis 53 repräsentiert den geschlossenen Schalter, d.h. der SPM 20 ist geschlossen und der Thyristor 9 offen. Die Position 54 verdeutlicht schließlich das betriebsmäßige Ausschalten des Schalters, wobei in diesem Fall der SPM 20 offen ist und die Thyristoransteuerschaltung 30 aktiviert ist.

Die Übergänge zwischen den vier Positionen 51 bis 54 verdeutlichen als Aktionen die Einschaltbefehle und das Kurzschlusserkennen zwischen den verschiedenen Zuständen: Beispielsweise gibt der Pfeil von Position 51 auf Position 52 den Einschaltbefehl wieder. Der Pfeil von Position 52 auf Position 51 gibt die Kurzschlusserkennung wieder. Der Pfeil von Position 54 auf Position 53 verdeutlicht, wie der Strom vom Thyristor 9 auf den SPM 20 kommutiert. Der Pfeil von Position 52 auf Position 54 gibt den Ausschaltbefehl wieder, bei dem der Thyristor 9 gezündet und der SPM 20 ausgeschaltet wird. Der Pfeil von Position 54 auf Position 53 verdeutlicht die Kurzschlusserkennung, bei dem der SPM 20 eingeschaltet wird. Schließlich zeigt der Pfeil von Position 54 auf Position 51 das Abschalten des Thyristors 9 im Stromnullgang.

Anhand der Figuren 6 bis 9 wird gezeigt, dass das Einschalten durch den SPM 20 erfolgt und dass im Normalzustand der Strom im SPM 20 geführt wird. Das Kurzschlussausschalten erfolgt jeweils durch den SPM 20. Der Thyristor wird dann nicht angesteuert.

Die Maßnahme Kurzschluss-AUS-Schalten entsprechend dem einen Pfad der Figur 4 ist in der Figur 6 verdeutlicht. Dargestellt ist in den einzelnen i(t)-Teildiagrammen a) bis c) die Ansteuerung 61 und der Gesamtstrom 63 (Teildiagramm a), die SPM-Ansteuerung 64 mit dem SPM-Strom 65 (Teildiagramm b) und die Thyristoransteuerung mit dem Thyristorstrom (Teildiagramm c - leer). Der Pfeil 62 gibt den Zeitpunkt an, bei der der Kurzschluss erkannt ist. Das Kurzschlussausschalten erfolgt durch den SPM. Der Thyristor wird nicht angesteuert.

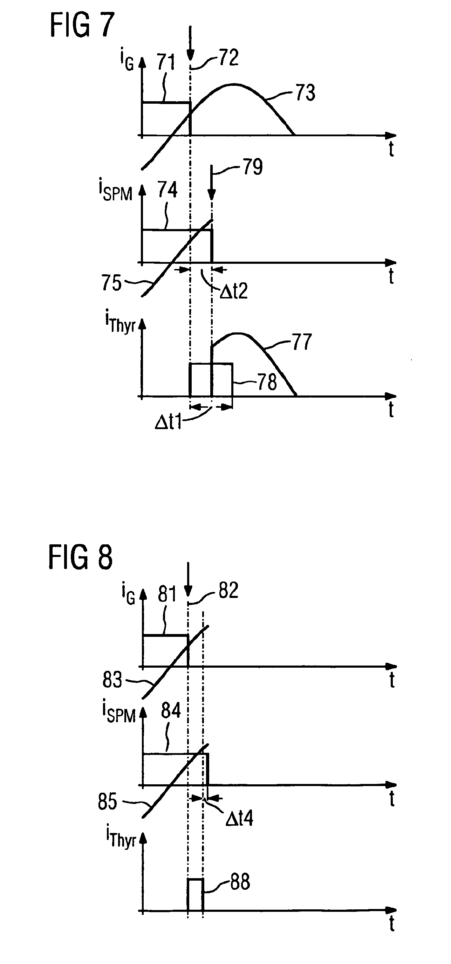

Die Figur 7 verdeutlicht das betriebsmäßige Überlast-AUS-Schalten, wobei die Teildiagramme a) bis c) mit Strömen 73, 75 und 77 entsprechend Figur 6 aufgebaut sind. Pfeil 72 gibt den Ausschaltbefehl wieder und Zeitpfeil 79 stellt den Zeitpunkt der Kommutierung dar.

Das Einschalten erfolgt durch den SPM. Im Normalzustand wird der Strom im SPM geführt. Das Ausschalten im Nulldurchgang bei Strömen bis in den zulässigen Überstrombereich erfolgt durch den Thyristor. Hierbei erfolgt zunächst ein Ansteuern des Thyristors und kurz darauf folgend ein Abschalten des SPM. Der Strom erlischt dann selbsttätig im Nulldurchgang.

Wenn während des Ausschaltens vor dem Stromnulldurchgang ein Kurzschluss auftritt, gibt der SPM keine Kurzschlussmeldung an den Baustein 10. Die Logik erhält den Befehl zur Kurzschlussabschaltung über die U_{DS}-Erfassung. Die Logik schaltet dann kurzfristig den SPM ein. Wenn der Strom auf den SPM kommutiert ist, was bei dem kleinen ON-Widerstand des SPM sehr schnell vonstatten geht, wird abgeschaltet. Der gesamte Vorgang findet in wenigen ps statt. Da der SiC-JFET sehr robust ist, wird er in dieser Zeit nicht geschädigt. Es ergibt sich ein Ablaufen entsprechend Figur 8 mit den Strömen 83, 85 und 87 in den Teildiagrammen, dem Zeitpfeil 81 für den Ausschaltbefehl und dem Signal 82 für das Erkennen des Kurzschlusses.

Entsprechendes ergibt sich durch Kurzschluss-AUS-Schalten, bei dem der Thyristor 9 angesteuert wird und der SPM 20 leitet.

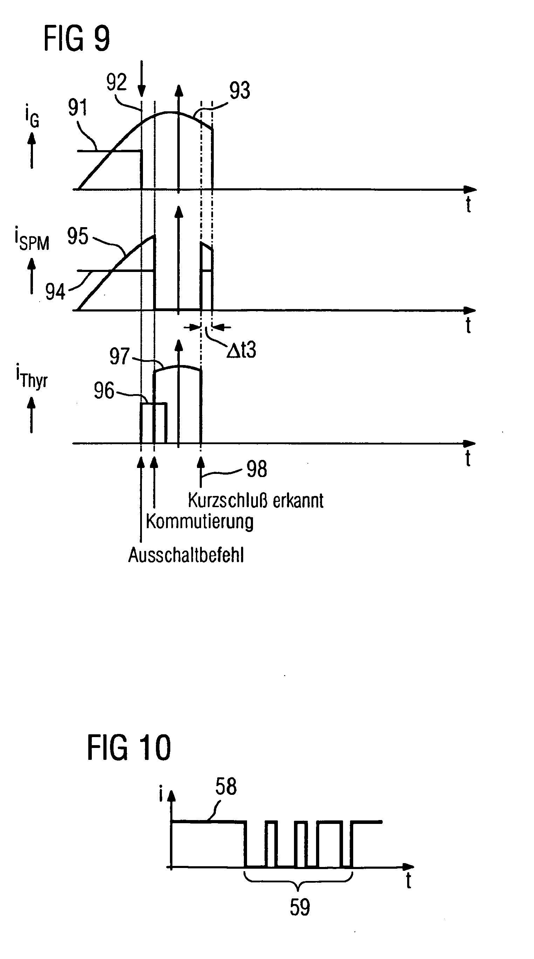

In Figur 9 ist das Kurzschluss-Aus-Schalten bei eingeschaltetem Thyristor 9 dargestellt, wobei die einzelnen Teildiagramme a) bis c) mit den Strömen wiederum den vorhergehenden Figuren 6 bis 8 entsprechen. 91 gibt die Ansteuerung, Zeitpfeil 92 den Ausschaltbefehl und 93 den Gesamtstrom wieder. 94 zeigt die SPM-Ansteuerung, 95 den SPM-Strom, 96 die Thyristor-Ansteurung und 97 den Thyristorstrom nach der Thyristoransteuerung 96. Beim Zeit-Pfeil 98 ist der Kurzschluss erkannt.

Insgesamt ergibt sich eine potentialgetrennte Ansteuerung der Einheiten durch einen Optokoppler 11, 11' und einen Überspannungsschutz durch den Varistor 8. Optokoppler 11, 11' und Varistor 8 sind in der weiter oben beschriebenen Figur 2 einzeln als Einheiten verdeutlicht. Es kann weiterhin eine Temperaturmessung vorgesehen sein, was dem thermischen Überlastschutz dient.

In der Figur 10 ist dargestellt, wie die Statusmeldung auch komplexe Fehlerzustände über den Optokoppler 11, 11' übertragen kann. Wenn kein Fehler besteht, ist das ausgegebene Signal 58 HIGH ("life zero"), bei Auftreten eines Fehlers wird dies durch die fallende Flanke indiziert. Das nachfolgende Bitmuster 59 kennzeichnet die Fehlerart.

Bei der Figur 2 erfolgt die Stromversorgung auf Schalterpotential mit einer bekannten Stromversorgung (Diode 24, 24', Widerstand 25, 25', Kondensator 26, Zenerdiode 27 aus Figur 2) aus der Netzspannung. Hierbei ist erforderlich, dass - selbst wenn der elektronische Leistungsschalter dauernd leiten soll - ein Mindestzündwinkel, während der der Schalter nichtleitend ist, vorhanden sein muss, um eine Aufladung des Kondensators zu gewährleisten.

Bei alternativen Schaltungsvarianten können auch Schaltungen eingesetzt werden, bei der statt des Einsatzes eines Varistors ein sog. "Clamping" über den gesamten SPM 20 erfolgt, was insbesondere dann möglich wird, wenn der Gate-Anschluss zugänglich ist.

Mit einer Anordnung gemäß Figur 2 und der softwaremäßigen Realisierung der Logikschaltung 10 ergeben sich insgesamt folgende Vorteile:

Im Kurzschluss erfolgt unverzögert das AUS: Durch den SPM ist keine diskrete Schaltung notwendig. Durch die Koordinierung mit dem Kurzschlussschutz des SPM ist kein separater Schutz notwendig.

Das Ausschalten bei Betriebs- und Überlastströmen erfolgt im Stromnulldurchgang. Durch die Verwendung eines Thyristors 9 ist keine aufwendige Komparatorschaltung mit separater Strommessung notwendig. Der Überlastschutz erfolgt über die Kaskode. Durch Koordinierung mit dem Überlastschlussschutz des SPM ist wiederum kein separater Schutz für den SiC-JFET notwendig.

Bei der Figur 2 kann die Ansteuerschaltung 30 als ein Steuerteil eines bekannten Sanftstarters mehr oder weniger unverändert eingesetzt werden. Es ergibt sich eine potentialgetrennte Ansteuerung und weiterhin eine potentialgetrennte Statusmeldung. Die Stromversorgung liegt auf Schalterpotential.

## Patentansprüche

1. Elektronisches Schaltgerät, insbesondere elektronischer Leistungsschalter, bei dem folgende Schaltfunktionen möglich sind:
- ein unverzögertes Einschalten, ggf. auch phasengesteuertes Einschalten,
- ein unverzögertes betriebsmäßiges Ausschalten, ein Ausschalten im Stromnulldurchgang, und zwar sowohl betriebsmäßig als auch bei Überlast,
- ein sofortiges Ausschalten als Kurzschlussschutz, mit einem Überlastschutz, gegebenenfalls einem Überlastschutz im Abzweig und einem Überspannungsschutz,
- mit einer potentialgetrennten Ansteuerung, einer potentialgetrennten Statusmeldung und einer Stromversorgung auf Schalterpotential,
mit einer Waskodenschaltung eines SiC-JFET (1, 1') mit einem als (Smart Power MOSFET SPM ausgebildeten MOSFET (2, 2'; 20) und wenigstens einem Thyristor (9), wobei der Thyristor (9) dem SPM (20) parallel geschaltet ist und wobei der Waskodenschaltung von SiC-JFET (1, 1') und SPM (20) mit parallel geschaltetem Thyristor (9) eine Logik-Schaltung (10) zugeordnet ist.

2. Elektronisches Schaltgerät nach Anspruch 1, **dadurch gekennzeichnet, dass** dem wenigstens einen Thyristor eine potentialmäßig entkoppelte Ansteuerschaltung (30) zugeordnet ist.

3. Elektronisches Schaltgerät nach Anspruch 2, **dadurch gekennzeichnet, dass** die Funktionen "phasengesteuertes Einschalten" und "Überlastschutz/Abzweig" in Verbindung mit den anderen Phasen in der Thyristor-Ansteuerschaltung (30) realisiert sind.

4. Elektronisches Schaltgerät nach Anspruch 2, **dadurch gekennzeichnet, dass** die Thyristor-Ansteuerschaltung (30) eine Überlastschutzeinheit realisiert.

5. Elektronisches Schaltgerät nach Anspruch 1, **dadurch gekennzeichnet, dass** der SPM (20)für das unverzögerte Einschalten, das unverzögerte Ausschalten, den Kurzschlussschutz, die Strombegrenzung und den Überlastschutz bewirkt.

6. Elektronisches Schaltgerät nach Anspruch 5,
**dadurch gekennzeichnet, dass** eine Ansteuerschaltung (30) vorhanden ist, dass der wenigstens eine Thyristor (9) für das Ausschalten im Stromnulldurchgang vorhanden ist und dass die Logikschaltung (10) zur Koordinierung des SPM (20) und dem wenigstens einen Thyristor (9) dient.

7. Elektronisches Schaltgerät nach einem der vorhergehenden Ansprüche, **dadurch gekennzeichnet, dass** Mittel (11, 11') zur Potentialtrennung, insbes. Optokoppler, vorhanden sind.

8. Elektronisches Schaltgerät nach einem der vorhergehenden Ansprüche, **dadurch gekennzeichnet, dass** Mittel zum Überspannungsschutz, insbes. Varistoren (8), vorhanden sind.

9. Elektronisches Schaltgerät nach einem der vorhergehenden Ansprüche, **dadurch gekennzeichnet, dass** Mittel zur Temperaturmessung und zum thermischen Überlastschutz vorhanden sind.

10. Betriebsweise eines elektronischen Schaltgerätes nach Anspruch 1 oder einem der Ansprüche 2 bis 9, **dadurch gekennzeichnet, dass** in einer logischen Abfolge die Zustände abgefragt und ergebnisabhängig der SPM und/oder die Thyristor-Ansteuerschaltung angesteuert werden.

11. Betriebsweise nach Anspruch 10, **dadurch gekennzeichnet, dass** zunächst der SPM und anschließend die Thyristor-Ansteuerschaltung eingreifen.

12. Betriebsweise nach Anspruch 10, **dadurch gekennzeichnet, dass** die logische Abfolge softwaremäßig erfolgt.

13. Betriebsweise nach Anspruch 10, **dadurch gekennzeichnet, dass** eine Logikschaltung mit Ablaufsteuerung verwendet wird.

## Claims

1. Electronic switching device, especially electronic circuit breaker, in which the following switching functions are possible:
- an undelayed switch-on, if nec. also a phase-controlled switch-on,
- an undelayed operational switch-off at the zero crossing point of the current, and this being done both during operation and on overload,
- an immediate switch-off as a short-circuit protection, with overload protection, if necessary an overload protection in the branch circuit and an overvoltage protection,
- with an isolated activation, an isolated status message and a power supply at switch potential,
with a cascade circuit of an SiC-JFET (1, 1') with a MOSFET (2, 2'; 20) embodied as a so-called Smart Power MOSFET and at least one thyristor (9), with the thyristor (9) being arranged in parallel with the SPM (20) and with the cascade circuit of SiC-JFET (1, 1') and SPM (20) with parallel switched thyristor (9) being assigned a logic circuit (10).

2. Electronic switching device according to claim 1, **characterised in that** a potential-decoupled activation circuit (30) is assigned to the at least one thyristor.

3. Electronic switching device according to claim 2, **characterised in that** the functions "phase-controlled switch-on" and "overload protection/branch" are implemented in conjunction with the other phases in the thyristor activation circuit (30).

4. Electronic switching device according to claim 2, **characterised in that** the thyristor activation circuit (30) implements an overload protection unit.

5. Electronic switching device according to claim 1, **characterised in that** the SPM (20) brings about short-circuit protection, current limiting and overload protection for undelayed switching on, undelayed switching off.

6. Electronic switching device according to claim 5, **characterised in that** an activation circuit (30) is present, that the at least one thyristor (9) for switching off at the zero current crossing point is present and that the logic circuit (10) is used for coordination of the SPM (20) and the at least one thyristor (9).

7. Electronic switching device according to one of the previous claims, **characterised in that** means (11, 11') for potential isolation, especially optocouplers, are present.

8. Electronic switching device according to one of the previous claims, **characterised in that** means for overvoltage protection, especially varistors (8), are present.

9. Electronic switching device according to one of the previous claims, **characterised in that** means for temperature measuring and for thermal overload protection are present.

10. Method of operation of an electronic switching device according to claim 1 or one of claims 2 to 9, **characterised in that** the states are interrogated in a logical sequence and, depending on the result, the SPM and/or the thyristor/activation circuit are activated.

11. Method of operation according to claim 10, **characterised in that** first the SPM and subsequently the thyristor activation circuit cut in.

12. Method of operation according to claim 10, **characterised in that** the logical sequence is undertaken using software.

13. Method of operation according to claim 10, **characterised in that** a logic circuit with scheduling is used.

## Revendications

1. Appareil électronique de commutation, notamment disjoncteur électronique, dans lequel les fonctions de commutation suivantes sont possibles :
- une connexion sans retard, le cas échéant, une connexion aussi commandée en phase,
- une déconnexion de service sans retard, une déconnexion au passage par un courant nul et cela à la fois en service et en surcharge,
- une déconnexion immédiate en tant que protection vis-à-vis d'un court-circuit, comprenant une protection en cas de surcharge, le cas échéant, une protection en cas de surcharge en dérivation et une protection vis-à-vis d'une surtension,
- une commande séparée en potentiel, une indication de statut séparée en potentiel et une alimentation en courant au potentiel du disjoncteur,
comprenant un circuit cascode d'un SiC-JEFT ( 1, 1' ), comprenant un MOSFET ( 2, 2', 20 ) constitué sous la forme d'un Smart Power MOSFET SPM et au moins un thyristor ( 9 ), le thyristor étant monté en parallèle au SPM ( 20 ), et dans lequel il est associé un circuit ( 10 ) logique au circuit cascode du Sic-JFET ( 1, 1' ) et du SPM ( 20 ) ayant le thyristor ( 9 ) monté en parallèle.

2. Appareil électronique de commutation suivant la revendication 1, **caractérisé en ce qu'**un circuit ( 30 ) de commande, découplé en potentiel, est associé au au moins un thyristor.

3. Appareil électronique de commutation suivant la revendication 2, **caractérisé en ce que** les fonctions "connexion commandée en phase" et "protection vis-à-vis d'une surcharge/dérivation" sont réalisées en liaison avec les autres phases dans le circuit ( 30 ) de commande du thyristor.

4. Appareil électronique de commutation suivant la revendication 2, **caractérisé en ce que** le circuit ( 30 ) de commande du thyristor réalise une unité de protection vis-à-vis d'une surcharge.

5. Appareil électronique de commutation suivant la revendication 1, **caractérisé en ce que** le SPM ( 20 ) agit pour la connexion sans retard pour la déconnexion sans retard, pour la protection vis-à-vis d'un court-circuit, pour la limitation de courant et pour la protection vis-à-vis d'une surcharge.

6. Appareil électronique de commutation suivant la revendication 5, **caractérisé en ce qu'**un circuit ( 30 ) de commande est présent, **en ce que** le au moins un thyristor ( 9 ) est présent pour la déconnexion au passage par un courant nul et **en ce que** le circuit ( 10 ) logique ne sert qu'à coordonner le SPM ( 20 ) et le au moins un thyristor ( 9 ).

7. Appareil électronique de commutation suivant l'une des revendications précédentes, **caractérisé en ce qu'**il y a des moyens ( 11, 11' ) de séparation du potentiel, notamment un optocoupleur.

8. Appareil électronique de commutation suivant l'une des revendications précédentes, **caractérisé en ce qu'**il y a des moyens de protection vis-à-vis d'une surtension, notamment des varistances ( 8 ).

9. Appareil électronique de commutation suivant l'une des revendications précédentes, **caractérisé en ce qu'**il y a des moyens de mesure de la température et de protection vis-à-vis de la surcharge thermique.

10. Mode de fonctionnement d'un appareil électronique de commutation suivant la revendication 1 ou l'une des revendications 2 à 9, **caractérisé en ce que**, dans une succession logique, on interroge les états et, en fonction du résultat, on commande le SPM et/ou le circuit de commande du thyristor.

11. Mode de fonctionnement suivant la revendication 10, **caractérisé en ce que** d'abord le SMP et ensuite le circuit de commande du thyristor interviennent.

12. Mode de fonctionnement suivant la revendication 10, **caractérisé en ce que** la succession logique s'effectue par logiciel.

13. Mode de fonctionnement suivant la revendication 10, **caractérisé en ce qu'**un circuit logique est utilisé avec une commande de déroulement.
